# EUROPEAN PATENT APPLICATION

(11) **EP 2 444 591 A2**
(43) Date of publication of application: **25.04.2012**
(21) Application number: 11185263.8
(22) Date of filing: 14.10.2011
(51) Int. Cl.: F01D 5/14

(54) **Turbine component and method for developing a component**

(30) Priority: 25.10.2010 US 910926
(71) Applicant: United Technologies Corporation, Hartford, CT 06101 (US)
(72) Inventor: Staroselsky, Alexander, Avon, CT Connecticut 06001 (US); Piggush, Justin D., La Crosse , WI Wisconsin 54601 (US); Mongillo, Dominic J., West Hartford, CT Connecticut 06107 (US)
(74) Representative: Hall, Matthew Benjamin

(57) **Abstract**

A method for developing a component (20) includes establishing a performance requirement to predict the secondary crystallographic orientation for a component having orthogonal x, y, and z axes. The component is to be formed from a single crystal material having a primary crystallographic orientation along the z-axis and a secondary crystallographic orientation substantially in the x-y plane. A property of the component is computer simulated as a function of an angle of the secondary crystallographic orientation relative to the x-axis. Based on the computer simulation, the angle for the component is selected which will substantially satisfy the performance requirement.

## Description

This disclosure relates to components formed from single crystal materials.

Single crystal materials are used to make turbine engine airfoils and other components where creep and thermo-mechanical fatigue are design factors. A predetermined crystallographic direction of the single crystal material is normally aligned along the long axis of the airfoil to enhance performance of the airfoil. Normally, the orientation of other crystallographic directions is not controlled.

Viewed from a first aspect, the present invention provides a method for developing a component, the method comprising:
establishing a performance requirement for a component having orthogonal x, y, and z axes, wherein the component is to be formed from a single crystal material having a primary crystallographic orientation along the z-axis and a secondary crystallographic orientation substantially in the x-y plane;
computer simulating a property of the component as a function of an angle of the secondary crystallographic orientation relative to the x-axis; and
based on the computer simulation, selecting the angle for the component which will substantially satisfy the performance requirement.

Thus in the present invention a method for developing a component includes establishing a performance requirement for a component having orthogonal x, y, and z axes. The component is to be formed from a single crystal material having a primary crystallographic orientation substantially along the z-axis and a secondary crystallographic orientation substantially along the x-y plane. A property of the component is computer simulated as a function of an angle of the secondary crystallographic orientation relative to the x-axis. Based on the computer simulation, the angle of the secondary crystallographic orientation is selected which will substantially satisfy the performance requirement.

In another aspect, the method includes establishing a creep and fatigue performance requirement for a turbine airfoil component. Damage and life prediction at a plurality of locations on the turbine airfoil is computer simulated as a function of an angle of the secondary crystallographic orientation relative to the x-axis and, based on the computer simulation, the angle of the secondary crystallographic orientation is selected which will satisfy the fatigue performance requirement.

An exemplary turbine component includes an airfoil made of a single crystal material having a primary crystallographic orientation and a secondary crystallographic orientation. The secondary crystallographic orientation is at an angle of 10°-20° relative to an x-axis that is parallel to the central axis of a turbine engine.

Certain preferred embodiments of the present invention will now be described in greater detail by way of example only and with reference to the drawings, in which:
Figure 1 illustrates an example component having a primary crystallographic orientation and a secondary crystallographic orientation that is controlled relative to the x-axis;
Figure 2 illustrates a sectional view of a typical component of Figure 1;
Figure 3 illustrates an example method for developing a component; and
Figure 4 illustrates a graph of strain versus angle of secondary crystallographic orientation for specific airfoil location.

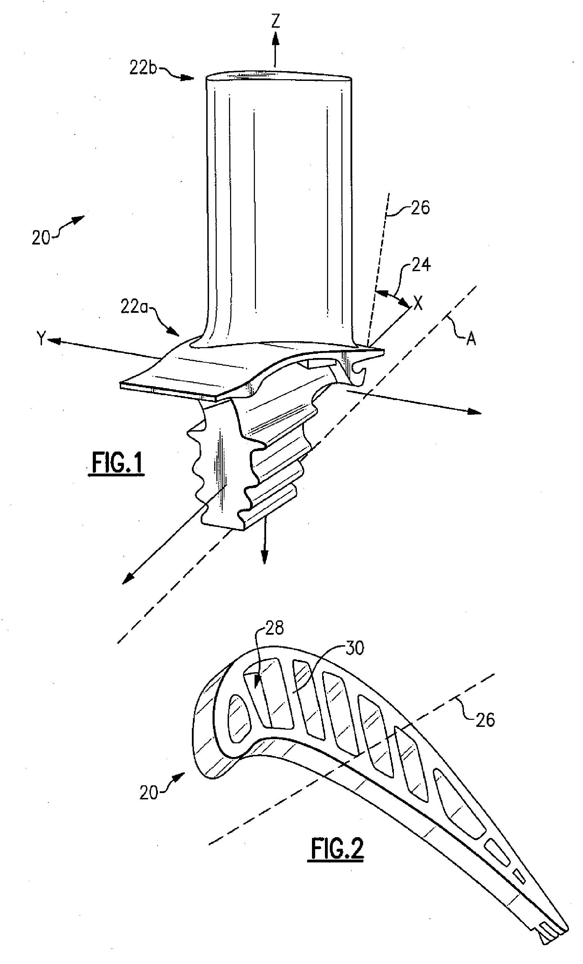

Figure 1 illustrates selected portions of an example component 20 that is made of a single crystal material, such as a superalloy. In this example, the component 20 is a turbine airfoil that may be used within a turbine engine. However, it is to be understood that the component is not limited to turbine airfoils or engine components and may alternatively be another type of component.

The single crystal material is not limited to any particular kind, but may be a nickel-based material or a cobalt-based material, for example. The single crystal material generally has a primary crystallographic orientation. The primary crystallographic orientation may be the crystallographic direction that has the lowest modulus of elasticity with regard to other crystallographic directions of the single crystal material. In other examples, the primary crystallographic orientation is simply a preselected or desired crystallographic direction of the single crystal material. In a face centered cubic crystal structure the primary crystallographic orientation may be [100] and the secondary crystallographic orientation may be [010]. Alternatively, other crystallographic directions may be selected for the primary and secondary orientations. Also, the primary and secondary crystallographic orientations may be different for other crystal structures.

In the embodiment of the turbine airfoil, the primary crystallographic orientation may be substantially aligned along a predetermined direction of the turbine airfoil. As an example, the turbine airfoil has orthogonal x, y, and z axes (see Figure 1). The x-axis is parallel to a central axis A of the turbine engine in which the turbine airfoil is used (e.g., along the shaft or spool of the engine). The z-axis is perpendicular to the x-axis and extends between radially inner and outer ends 22a and 22b of the turbine airfoil. The y-axis is perpendicular to the x-axis and the z-axis.

The secondary crystallographic orientation of the alloy can be controlled during fabrication of the component 20 such that the secondary crystallographic orientation forms a predefined angle 24 with regard to the x-axis. The fabrication may include casting the component 20 using known seeding technology. Crystal orientation in the plane perpendicular to the primary orientation axis is considered to be the secondary orientation. The secondary crystallographic orientation, as represented by line 26, substantially forms the angle 24 to the x-axis. In some examples, the angle 24 may be 10°-20°. As will be described in more detail below, the angle 24 that is selected for the secondary crystallographic orientation based upon a computer simulation of the component 20, which simulates a property of the component as a function of the angle 24. The angle 24 can thereby be selected to enhance a particular performance requirement of the component 20.

Figure 2 illustrates a cutaway section of the component 20, which in this example is a hollow turbine airfoil that has internal cooling passages 28 defined by internal ribs 30 that extend generally along the length of the turbine airfoil. The angle 24 of the secondary crystallographic orientation of at least the internal ribs 30 is controlled to be within the above-noted angular ranges with regard to the x-axis. The remaining portions of the turbine airfoil has the same angle 24 of the secondary crystallographic orientation.

In operation of the component 20, such as a turbine airfoil, different locations of the component experience different temperatures and strain levels. Over the life of the component 20, the stresses on the component 20 generally redistribute from hot temperature locations to cold temperature locations. On the illustrated airfoil, the stresses redistribute from the outer surfaces to the internal ribs 30. In this regard, the angle 24 of the secondary crystallographic orientation is selected based upon creep and/or fatigue performance requirements at the critical locations of the part. We will call the critical location, such a location where the calculated damage parameter meet some critical values or reaches the maximum value. Depending on criterion, the critical location must be the location with the lowest calculated life expectancy, which, in turn, depends on strain, temperature, and possibly other state parameters.

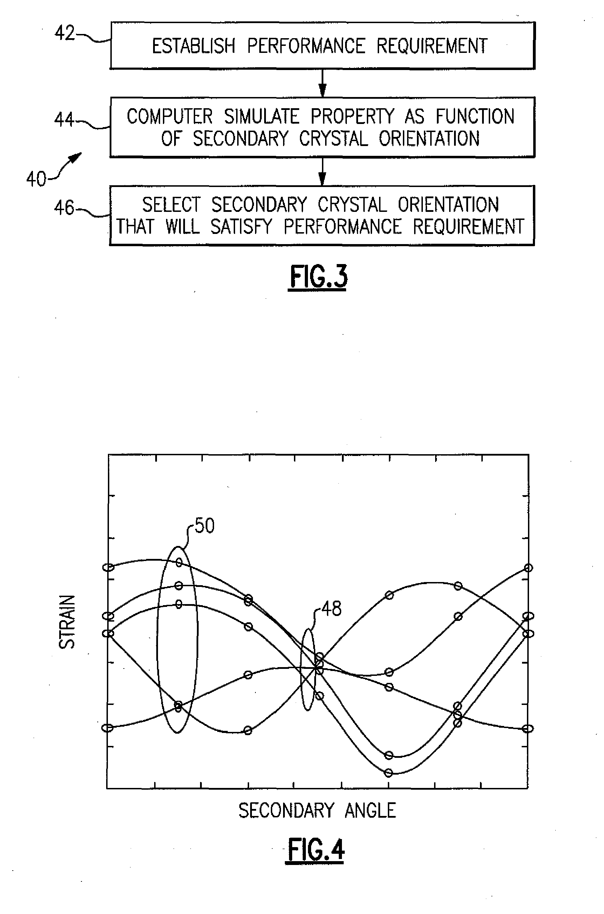

Figure 3 illustrates an example method 40 for developing the component 20. The method 40 generally includes step 42, 44, and 46. Step 42 establishes a performance requirement of the component 20. As an example, the performance requirement may be a creep and fatigue performance requirement, such as to enhance creep and fatigue life of a turbine airfoil versus a comparable turbine airfoil where the secondary crystallographic orientation is not controlled. In a further example, the performance requirement is a damage criterion that is determined as a function of accumulated inelastic strain, energy rate, life expectancy, or combinations thereof with regard to total strain and temperature.

The step 44 computer simulates a property of the component as a function of the angle 24 of the secondary crystallographic orientation. For instance, the computer simulation may be run on a computer using finite element modeling software. The simulation may include a non-linear analysis based on creep predictions and a corresponding stress re-distribution. The computer simulation shall be based, at least in part, on the elastic-viscoplastic properties of the single crystal material, such as creep and/or fatigue properties, and also on the expected operating temperature of the component and operating time of the component. For a turbine airfoil, the expected temperature and time may be based upon the operation temperature of the turbine engine and the desired useful life of the turbine airfoil.

The inputs may be used to simulate a predefined property of the component 20, such as damage and life prediction. The damage and life prediction may be a function of total strain, inelastic strain, stress and dissipated energy rate as well as any other chosen damage parameter at a plurality of different locations on the component 20 as a function of the angle 24 of the secondary crystallographic orientation. The different locations selected may be among a variety of hot and cold locations where the critical damage has been located on the component 20. Figure 4 illustrates an example showing computer simulated strain levels as a function of different angles 24 of the secondary crystallographic orientation for different locations on the component 20.

At step 46, a user selects the angle 24 of the secondary crystallographic orientation for the component 20 which will substantially satisfy the performance requirement based upon the computer simulation, such as the graphic representation shown in Figure 4. For instance, the angle 24 of the secondary crystallographic orientation may correspond to damage criteria over the plurality of different locations that is lowest among all the simulated angles 24. Alternatively, the selected angle 24 of the secondary crystallographic orientation may correspond to the angle 24 that produces the lowest amount of strain, dissipated energy or any other specific damage parameter at the critical location among the different locations on the component.

In Figure 4, the region represented at 48 illustrates one example where the angle 24 of the secondary crystallographic orientation produces the lowest cumulative strain over all of the simulated angles 24. The region represented at 50 illustrates the angle 24 at which some of the locations exhibited a relatively high level of strain, but at which at least one of the locations which is hottest among all of the locations exhibited the lowest level of strain, energy or induced damage value compared to other simulated angles 24. As an example, the region at 48 may correspond to an angle of 10°-20°. Thus, fabricating a turbine airfoil such that the angle 24 of the secondary grain orientation is at the angle of 37°-7° provides a low cumulative amount of strain that facilitates enhancing fatigue life. Alternatively, fabricating the component 20 such that the angle 24 of the secondary grain orientation is 10°-20° facilitates reducing the total accumulated damage to enhance fatigue life at the hottest location.

In comparison, other designs may take into consideration the material properties but do not take into consideration the non-linear creep properties of the material with regard to the application of strain over time at elevated temperatures. The disclosed method 40 thereby facilitates enhancement of a desired performance requirement with regard to controlling the angle of the secondary crystallographic orientation.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

Thus it can be seen that the present invention may provide a method for developing a component as set out in the following clauses:
1. A method for developing a component, the method comprising:
   establishing a creep and fatigue performance requirement for a turbine airfoil having orthogonal x, y, and z axes where the z-axis extends between radially inner and outer ends of the turbine airfoil, the x-axis is parallel to a turbine engine axis, and the y-axis is perpendicular to the turbine engine axis, wherein the turbine airfoil is to be formed from a single crystal material having a primary crystallographic orientation along the z-axis and a defined secondary crystallographic orientation substantially in the x-y plane;
   computer simulating damage and life prediction at a plurality of different locations on the turbine airfoil as a function of an angle of the secondary crystallographic orientation relative to the x-axis; and
   based on the computer simulation, selecting the angle for the turbine airfoil that will substantially satisfy the creep and fatigue performance requirement.
2. The method as recited in clause 1, including selecting the angle that has a cumulative damage over the plurality of different locations that is lowest compared to other angles.
3. The method as recited in clause 1, including selecting the angle that corresponds to a damage that is lowest at the hottest location of the plurality of different locations compared to other angles.
4. The method as recited in clause 1, wherein the selecting of the secondary crystallographic orientation is for minimizing the damage at least to an internal rib of the turbine airfoil.

The preceding description is exemplary rather than limiting in nature. Variations and modifications to the disclosed examples may become apparent to those skilled in the art that do not necessarily depart from the essence of this disclosure. The scope of legal protection given to this disclosure can only be determined by studying the following claims.

## Claims

1. A method for developing a component, the method comprising:
establishing a performance requirement for a component having orthogonal x, y, and z axes, wherein the component is to be formed from a single crystal material having a primary crystallographic orientation along the z-axis and a secondary crystallographic orientation substantially in the x-y plane;
computer simulating a property of the component as a function of an angle of the secondary crystallographic orientation relative to the x-axis; and
based on the computer simulation, selecting the angle for the component which will substantially satisfy the performance requirement.

2. The method as recited in claim 1, wherein the selecting of the secondary crystallographic orientation is for an internal rib of a turbine airfoil, where the z-axis extends between radially inner and outer ends of the turbine airfoil, the x-axis is parallel to a turbine engine central axis, and the y-axis is perpendicular to the turbine engine central axis.

3. The method as recited in claim 1 or 2, wherein the property is an elastic-viscoplastic property and/or total strain.

4. The method as recited in claim 1, 2 or 3, wherein the performance requirement is fatigue performance.

5. The method as recited in any preceding claim, wherein the performance requirement is a damage criterion that is determined as a function of accumulated inelastic strain, energy rate, temperature, life expectancy, or combinations thereof with regard to total strain and temperature.

6. The method as recited in any preceding claim, including computer simulating the property of the component using finite element modeling, and preferably wherein the finite element modeling includes input parameters of material creep properties of the single crystal material, component operating temperature, and time.

7. The method as recited in any preceding claim, wherein the component is a turbine airfoil such that the z-axis extends between radially inner and outer ends of the turbine airfoil, the x-axis is parallel to a turbine engine central axis, and the y-axis is perpendicular to the turbine engine central axis, and the computer simulating of the property of the component includes simulating a strain at a plurality of different locations of the turbine airfoil and selecting the angle that has a cumulative strain over the plurality of different locations that is lowest compared to other angles.

8. The method as recited in any preceding claim, wherein the component is a turbine airfoil such that the z-axis extends between radially inner and outer ends of the turbine airfoil, the x-axis is parallel to a turbine engine central axis, and the y-axis is perpendicular to the turbine engine central axis, and the angle is selected to be 10°-20° relative to the x-axis.

9. The method as recited in any preceding claim, wherein the component is a turbine airfoil such that the z-axis extends between radially inner and outer ends of the turbine airfoil, the x-axis is parallel to a turbine engine central axis, and the y-axis is perpendicular to the turbine engine central axis, and the computer simulating of the property of the component includes simulating a strain at a plurality of different locations on the turbine airfoil, and selecting the angle that corresponds to a strain that is lowest at the hottest location of the plurality of different locations compared to other angles.

10. A method for developing a component as claimed in claim 1, wherein the performance requirement is a creep and fatigue performance requirement, the component is a turbine airfoil where the z-axis extends between radially inner and outer ends of the turbine airfoil, the x-axis is parallel to a turbine engine axis, and the y-axis is perpendicular to the turbine engine axis, the secondary crystallographic orientation is a defined secondary crystallographic orientation, and the property is a damage and life prediction at a plurality of different locations on the turbine airfoil.

11. The method as recited in claim 10, including selecting the angle that has a cumulative damage over the plurality of different locations that is lowest compared to other angles.

12. The method as recited in claim 10 or 11, including selecting the angle that corresponds to a damage that is lowest at the hottest location of the plurality of different locations compared to other angles.

13. The method as recited in claim 10, 11 or 12, wherein the selecting of the secondary crystallographic orientation is for minimizing the damage at least to an internal rib of the turbine airfoil.

14. A turbine component comprising:
an airfoil having orthogonal x, y, and z axes where the z-axis extends between radially inner and outer ends of the airfoil, the x-axis is parallel to a turbine engine central axis, and the y-axis is perpendicular to the turbine engine central axis, the airfoil comprises a single crystal material having a primary crystallographic orientation along the z-axis and a secondary crystallographic orientation substantially in the x-y plane, and the secondary crystallographic orientation is at an angle of 10°-20° relative to the x-axis.

15. The turbine component as recited in claim 14, wherein at least an internal rib of the airfoil has the secondary crystallographic orientation.
